# EUROPÄISCHE PATENTANMELDUNG

(11) **EP 2 747 535 A2**
(43) Veröffentlichungstag der Anmeldung: **25.06.2014**
(21) Anmeldenummer: 13005569.2
(22) Anmeldetag: 29.11.2013
(51) Int. Cl.: H05K 7/20

(54) **Schaltschrank mit schwenkbarem Wärmetauscher**

(30) Priorität: 18.12.2012 DE 102012112507
(71) Anmelder: Rittal GmbH & Co. KG, 35745 Herborn (DE)
(72) Erfinder: Bloh, Achim, 35644 Hohenahr (DE); Bernhardt, Lisa, 35713 Eschenburg-Simmersbach (DE)
(74) Vertreter: Angerhausen, Christoph

(57) **Zusammenfassung**

Die Erfindung beschreibt einen Schaltschrank (1), mit einem Gehäuse (2) und einem daran um eine Schwenkachse (x) schwenkbar anscharnierten, ein Fluid führendes Bauteil (3), das eine Vorlaufleitung (4) für das Fluid und eine Rücklaufleitung (5) für das Fluid aufweist, dadurch gekennzeichnet, dass die Vorlaufleitung (4) und/oder die Rücklaufleitung (5) zumindest abschnittsweise koaxial zu der Schwenkachse (x) geführt sind.

## Beschreibung

Die Erfindung betrifft einen Schaltschrank, mit einem Gehäuse und einem daran um eine Schwenkachse schwenkbar anscharnierten, ein Fluid führendes Bauteil, das eine Vorlaufleitung für das Fluid und eine Rücklaufleitung für das Fluid aufweist. Das ein Fluid führende Bauteil ist vorzugsweise ein Wärmetauscher, beispielsweise ein Luft-Kältemittel-Wärmetauscher eines Kältemittelkreislaufes. Bei gattungsgemäßen Schaltschränken ist das Fluid führende Bauteil üblicherweise an einer Innenseite eines Türelements des Schaltschranks angeordnet. Der Wärmetauscher kann beispielsweise ein Verdampfer des Kältekreislaufes sein, wobei weitere, das Fluid führende Bauteile des Kältekreislaufes außerhalb des Türelements angeordnet sind, mit welchen der Verdampfer über die Vorlaufleitung bzw. die Rücklaufleitung für das Kältemittel fluidisch verbunden ist.

Um beim Verschwenken des Türelements zu vermeiden, dass die Vorlauf- bzw. die Rücklaufleitung Schaden nimmt, ist es aus der US 7,830,657 B2 bekannt, flexible Gummileitungen zu verwenden, welche beim Verschwenken der Schaltschranktür entsprechend der Schwenkbewegung nachgeben. Dazu sind der Kühlmittelvorlauf bzw. der Kühlmittelrücklauf nahe an der Türkante angeordnet. Ein ähnlicher Schaltschrank ist auch aus der US 7,963,118 B2 bekannt.

In ähnlicher Weise beschreibt auch die US 8,077,462 B2 einen Schaltschrank, bei dem für den Kühlmittelzulauf und den Kühlmittelrücklauf zwischen dem Türelement und dem Schaltschrankgehäuse flexible Leitungen verlegt sind.

Je nach Anwendungsgebiet des Schaltschrankes ist es für die Erzielung einer erforderlichen IP-Schutzklasse bzw. eines erforderlichen Vandalismusschutzes jedoch nachteilig, wenn die beschriebenen Verbindungsleitungen zwischen dem das Fluid führende Bauteil und dem Kältekreislauf mit Hilfe elastischer Gummileitungen ausgeführt sind. Vielmehr ist es wünschenswert, dass auch die Vorlaufleitung bzw. die Rücklaufleitung, welche zwischen dem das Fluid führende Bauteil und dem Kältekreislauf verlegt sind, aus einem starren Material, beispielsweise aus Metall, gefertigt sind.

Es ist daher die Aufgabe der Erfindung, einen gattungsgemäßen Schaltschrank derart fortzuentwickeln, dass er die Verwendung einer starren Vorlaufleitung und einer starren Rücklaufteilung zur fluidischen Anbindung des anscharnierten, ein Fluid führenden Bauteils erlaubt.

Diese Aufgabe wird erfindungsgemäß durch einen Schaltschrank mit den Merkmalen des Patentanspruchs 1 gelöst. Die abhängigen Ansprüche 2 bis 9 betreffen jeweils vorteilhafte Ausführungsformen der Erfindung.

Demgemäß sind die Vorlaufleitung und/oder die Rücklaufleitung zumindest abschnittsweise koaxial zu der Schwenkachse geführt. Dabei kann es ausreichen, dass die Vorlaufleitung bzw. die Rücklaufleitung lediglich in dem Bereich, in welchem sie nicht koaxial zu der Schwenkachse geführt ist, eine ausreichende Flexibilität aufweist. Dies kann bei Ausführungsformen der Erfindung lediglich die bauteilseitigen bzw. die gehäuseseitigen Enden der Vorlaufleitung bzw. der Rücklaufleitung betreffen, so dass wesentliche Abschnitte dieser aus einem starren Rohr, beispielsweise aus einem Metallrohr, gefertigt sein können. Um zu erreichen, dass die Vorlaufleitung bzw. die Rücklaufleitung vollständig aus einem starren Rohr gefertigt sein können, ist bei einer Ausführungsform vorgesehen, dass die Vorlaufleitung und/oder die Rücklaufleitung in einem koaxial zu der Schwenkachse geführten Abschnitt eine um die Schwenkachse verdrehbare Drehdurchführung aufweist. Derartige Drehdurchführungen zeichnen sich dadurch aus, dass sie zwei zueinander verdrehbare, koxial gelagerte und fluidisch dicht miteinander verbundene Abschnitte aufweisen, über welche zwei Enden der Vorlaufleitung bzw. der Rücklaufleitung miteinander verbunden werden können, so dass die Leitungen aufgrund der Drehdurchführung beim Verschwenken des anscharnierten Bauteils abschnittsweise starr gegenüber dem das Fluid führende Bauteil und abschnittsweise starr gegenüber dem Gehäuse des Schaltschrankes ist.

Bei einer anderen Ausführungsform ist das ein Fluid führende Bauteil über mindestens ein Scharnier an dem Gehäuse anscharniert, wobei die Vorlaufleitung und/oder die Rücklaufleitung durch eine sich entlang der Schwenkachse erstreckende Durchführung in dem Scharnier geführt ist. Dabei weist besonders bevorzugt das Scharnier eine gehäuseseitige Scharnierhälfte und eine bauteilseitige Scharnierhälfte auf, wobei die Scharnierhälften fluchtende, sich entlang der Schwenkachse erstreckende Teildurchführungen aufweisen, und wobei die Scharnierhälften um die Schwenkachse zueinander verdrehbar gelagert sind.

Bei einer Ausführungsform der Erfindung weist das ein Fluid führende Bauteil eine Einhausung auf, die zwischen einer Schließstellung, in welcher die Einhausung in einer Öffnung des Gehäuses aufgenommen oder dieser vorgelagert ist, und einer Offenstellung, in welcher die Einhausung die Öffnung freigibt, verschwenkbar ist. Bevorzugt ist die Einhausung quaderförmig und weist eine vertikale Seiten- oder Rückwand auf, über welche die Einhausung an einer die gehäuseseitige Öffnung umrandenden Stirnseite des Gehäuses anscharniert ist.

Bei einer Ausführungsform der Erfindung ist in der Einhausung ein das Fluid führender Wärmeübertrager aufgenommen, an den die Vorlaufleitung und die Rücklaufleitung angeschlossen sind, welche sich von dem Wärmeübertrager durch die Seiten- oder Rückwand hindurch der Schwenkachse annähern und über mindestens ein Umlenkstück in den koaxial zu der Schwenkachse geführten Abschnitt übergeleitet sind.

Bei manchen Ausführungsformen der Erfindung ist die Einhausung an einer in der Schließstellung dem Gehäuse zugewandten Innenseite eines Türelements angeordnet, wobei die Einhausung entweder eine sich parallel beabstandet zu der Innenseite vertikal erstreckende Auslassseite für gekühlte Luft, oder eine sich horizontal erstreckende obere Begrenzungswand mit mindestens einer Luftauslassöffnung für gekühlte Luft aufweist, wobei das Türelement einen Einlass für Umgebungsluft in das Innere der Einhausung aufweist, und wobei ein Luft-Kältemittel-Wärmeübertrager in Luftströmungsrichtung zumindest abschnittsweise zwischen dem Einlass für Umgebungsluft und der Auslassseite für gekühlte Luft angeordnet ist.

Bei anderen Ausführungsformen ist die Einhausung an einer in der Schließstellung dem Gehäuse zugewandten Innenseite eines Türelements angeordnet, wobei die Einhausung in einer parallel zu der Innenseite beabstandeten Bewandung vertikal voneinander beabstandet sowohl einen Auslass für gekühlte Luft, als auch einen Einlass für Warmluft aufweist, wobei ein Luft-Kältemittel-Wärmeübertrager in Luftströmungsrichtung zumindest abschnittsweise zwischen dem Einlass für Warmluft und dem Auslass für gekühlte Luft angeordnet ist.

Weitere Einzelheiten der Erfindung werden anhand der nachstehenden Figuren erläutert. Dabei zeigt:
- Figur 1: eine perspektivische Teilansicht auf die Scharnierseite eines erfindungsgemäßen Schaltschrankes sowie eine Detailansicht des oberen Scharnieranschlages, wobei sich der Schaltschrank im teilweise geöffneten Zustand befindet;
- Figur 2: perspektivische Ansichten eines Wärmetauscherelementes einer ersten Ausführungsform;
- Figur 3: perspektivische Ansichten eines Wärmetauscherelements einer zweiter Ausführungsform;
- Figur 4: perspektivische Ansichten eines Wärmetauscherelementes einer dritten Ausführungsform; und
- Figur 5: eine perspektivische Teilansicht auf die Scharnierseite eines erfindungsgemäßen Schaltschrankes gemäß nocheiner anderen Ausführungsform.

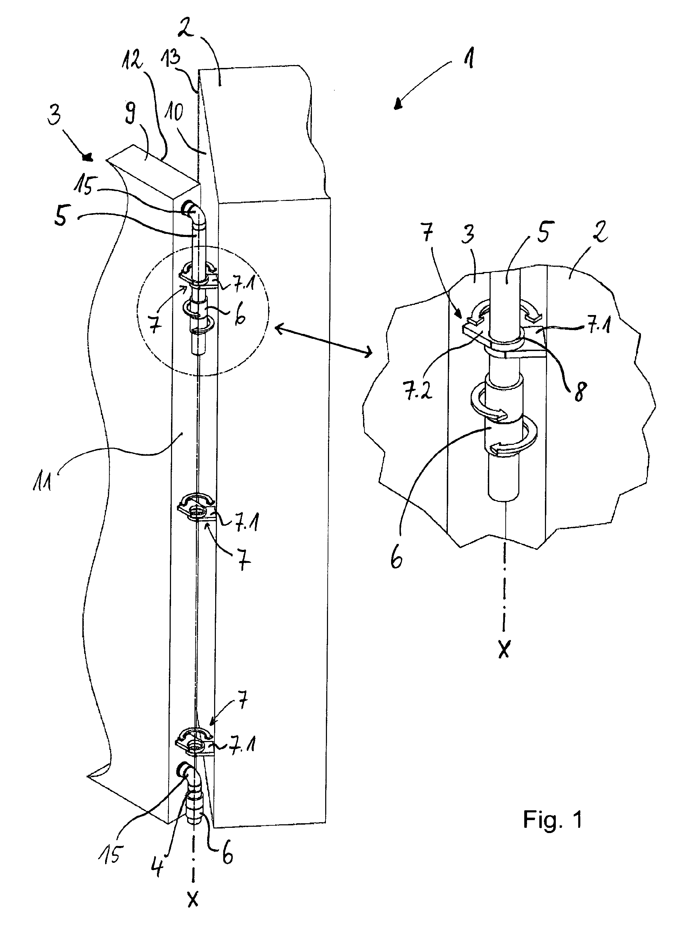

Bei dem in Figur 1 gezeigten Schaltschrank 1 ist das ein Fluid führende Bauteil 3 als ein Wärmetauscherelement ausgebildet. Das Wärmetauscherelement 3 ist über Scharniere 7 an dem Gehäuse 2 des Schaltschrankes 1 anscharniert. Das Wärmetauscherelement 3 weist ein im Wesentlichen quaderförmiges Metallgehäuse auf, in dem ein Wärmetauscher, beispielsweise ein Luft-Kältemittel-Wärmetauscher, aufgenommen ist. Die fluidische Anbindung des Wärmetauschers erfolgt über eine Vorlaufleitung 4 und eine Rücklaufleitung 5, die aus dem Innern der Einhausung 9 über Durchlässe in der Seitenwand 11 aus dem Wärmetauscherelement herausgeführt sind. An der Austrittsstelle der Vorlaufleitung 4 bzw. der Rücklaufleitung 5 ist diese jeweils über einen 90°-Bogen 15 in einen vertikalen Abschnitt der jeweiligen Leitung 4, 5 umgelenkt. Diese vertikalen Abschnitte sind jeweils koaxial zu der Schwenkachse x angeordnet, um welche das Wärmetauscherelement 3 mit der Einhausung 9 bezüglich dem Schaltschrankgehäuse 2 verschwenkbar ist. Drehdurchführungen 6 erlauben ein Verdrehen der Vorlaufleitung 4 bzw. der Rücklaufleitung 5 beim Verschwenken des Wärmetauscherelementes ohne mechanische Beanspruchung dieser. Zumindest die Rücklaufleitung 5 ist durch eine sich entlang der Schwenkachse x erstreckende Durchführung in dem oberen Scharnier 7 hindurchgeführt, wobei selbstverständlich auch die Durchführung 8 symmetrisch um die Schwenkachse x herum ausgebildet ist.

Das Scharnier 7 weist eine gehäuseseitige Scharnierhälfte 7.1 und eine wärmetauscherelementseitige Scharnierhälfte 7.2 auf, wobei die Scharnierhälften 7.1, 7.2 fluchtende, sich entlang der Schwenkachse x erstreckende Teildurchführungen aufweisen. Die Scharnierhälften 7.1, 7.2 sind um die Schwenkachse x zueinander verdrehbar gelagert.

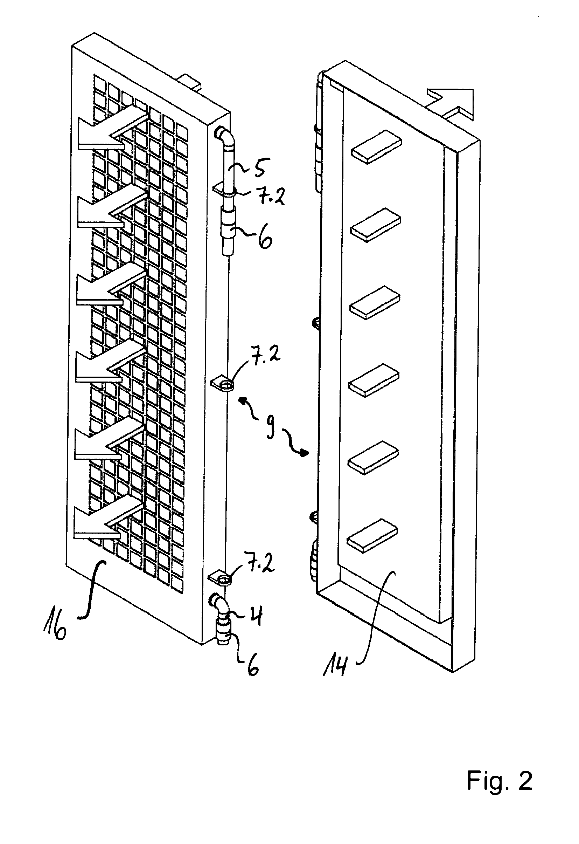

Die Figuren 2 bis 4 zeigen jeweils Ausführungsformen eines Wärmetauscherelementes für die Montage an der dem Schaltschrankinnenraum zugewandten Innenseite einer Schaltschranktür, welche gegenüber dem Schaltschrankgehäuse 2 (siehe Figur 1) um die Schwenkachse x verschwenkt werden kann.

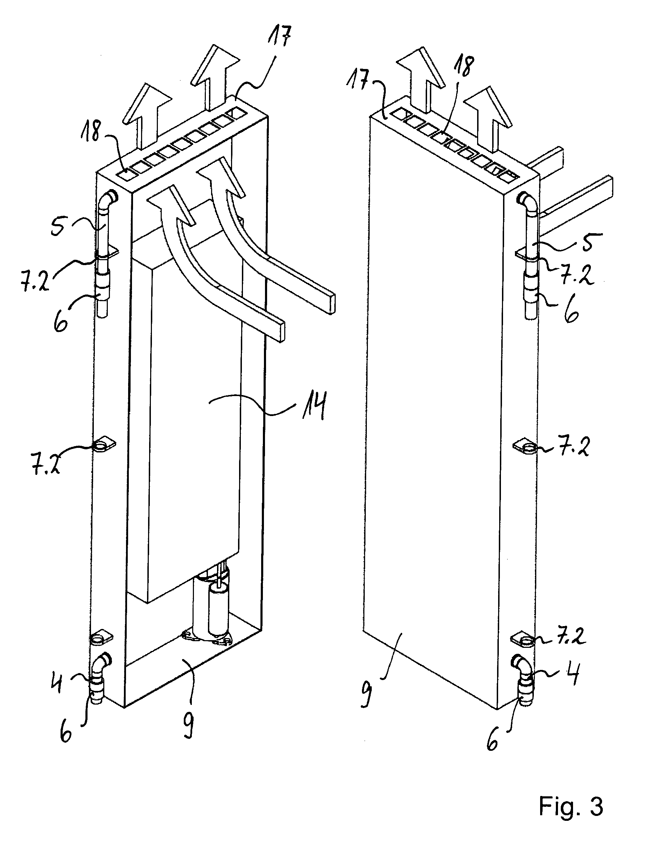

Die Ausführungsform gemäß Figur 2 ist für die Montage anstelle einer Schaltschranktür bzw. einer Schaltschrankrückwand vorgesehen, welche für das Ausblasen erwärmter Luft zumindest teilweise perforiert ist oder anderweitige Öffnungen aufweist. Wie durch die in Figur 2 angedeuteten Pfeile gekennzeichnet ist, soll die erwärmte Luft durch die nicht dargestellte Rückseite der Schaltschranktür hindurch, durch den Luft-Kältemittel-Wärmeübertrager 14 und abschließend durch die Auslassseite 16 der Einhausung 9 aus dem Schaltschrank heraus geführt werden. Das Wärmetauscherelement gemäß den Ausführungsformen der Figuren 2 bis 4 ist jeweils derart mit Bezug auf die Schaltschranktür und das Schaltschrankgehäuse anzuordnen, dass sich die vertikalen Abschnitte der Vorlaufleitung 4 und der Rücklaufleitung 5 koaxial zu der Schwenkachse erstrecken. Bei der Ausführungsform gemäß der Figur 3 erfolgt die Kaltluftausblasung aus dem Schaltschrank über Luftauslassöffnungen 18 in einer sich horizontal erstreckenden oberen (wahlweise auch einer unteren) Begrenzungswand 17 der Einhausung 9. Warmluft wird dabei in einem unteren Bereich der Einhausung 9 in diese hinein angesogen, durch den Luft-Kältemittel-Wärmeübertrager 14 hindurchgeführt und wie zuvor beschrieben durch die Luftauslassöffnungen 18 in der oberen oder unteren Begrenzungswand 17 aus dem Schaltschrankinneren herausgeleitet.

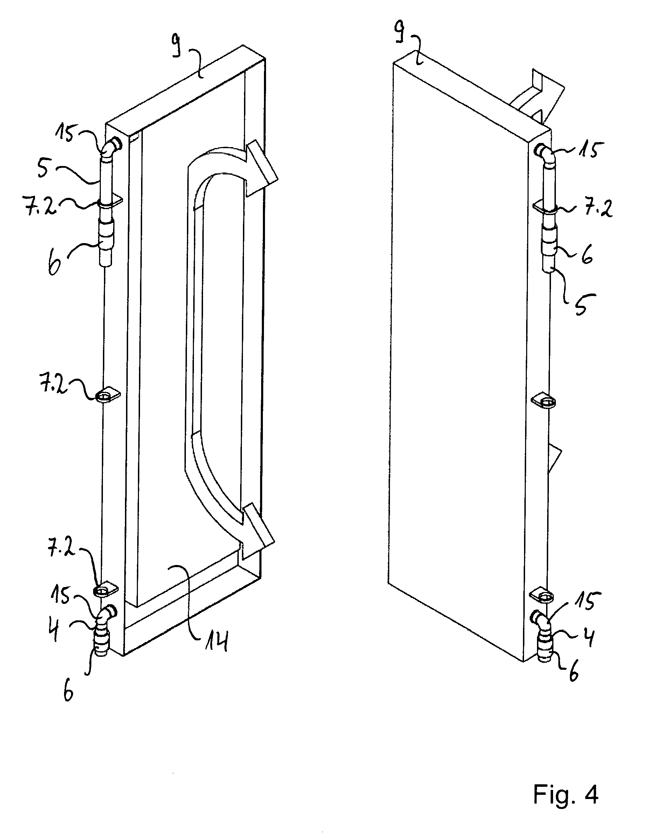

Bei der in Figur 4 gezeigten Ausführungsform befindet sich vertikal voneinander beabstandet an der dem Schaltschrankinnenraum zugewandten Seite der Einhausung 9 sowohl ein Einlass für Warmluft, als auch ein Auslass für gekühlte Luft. Es erfolgt somit sowohl die Warmluftansaugung als auch die Kaltluftausblasung über dieselbe Seite der Einhausung 9, nämlich die dem Gehäuseinneren zugewandte Seite der Einhausung 9. Infolgedessen sollten der Auslass für gekühlte Luft und der Einlass für Warmluft möglichst weit voneinander beabstandet angeordnet sein, um einen Luftkurzschluss zu vermeiden.

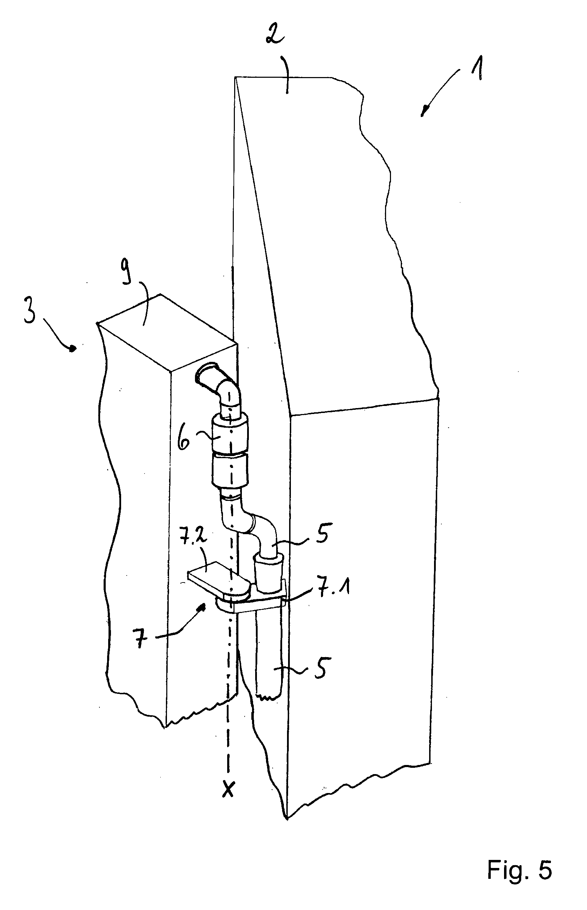

In Abwandlung zu der Ausführungsform gemäß Figur 1, ist bei der Ausführungsform gemäß Figur 5 die Rücklaufleitung 5 nicht koaxial zu der Drehachse durch eine Scharnierdurchführung in beiden Scharnierhälften 7.1, 7.2 hindurch geführt, sondern parallel versetzt zu der Drehachse durch lediglich eine Scharnierdurchführung 8 in einer der Scharnierhälften 7.1, 7.2, hier der bauteilseitigen Scharnierhälfte 7.2. Diese Ausführungsform hat den Vorteil gegenüber der gemäß Figur 1, dass die Stabilität des jeweiligen Scharniers 7 weniger beeinträchtigt wird.

Die in der vorstehenden Beschreibung, in der Zeichnung sowie in den Ansprüchen offenbarten Merkmale der Erfindung können sowohl einzeln als auch in beliebiger Kombination für die Verwirklichung der Erfindung wesentlich sein.

### Bezugszeichenliste

- 1: Schaltschrank
- 2: Gehäuse
- 3: ein Fluid führendes Bauteil
- 4: Vorlaufleitung
- 5: Rücklaufleitung
- 6: Drehdurchführung
- 7: Scharnier
- 7.1: gehäuseseitige Scharnierhälfte
- 7.2: bauteilseitige Scharnierhälfte
- 8: Scharnierdurchführung
- 9: Einhausung
- 10: Öffnung
- 11: Seitenwand
- 12: Rückwand
- 13: Stirnseite
- 14: Wärmeübertrager
- 15: Umlenkstück
- 16: Auslassseite
- 17: Begrenzungswand
- 18: Luftauslassöffnung
- x: Schwenkachse

## Patentansprüche

1. Schaltschrank (1), mit einem Gehäuse (2) und einem daran um eine Schwenkachse (x) schwenkbar anscharnierten, ein Fluid führendes Bauteil (3), das eine Vorlaufleitung (4) für das Fluid und eine Rücklaufleitung (5) für das Fluid aufweist, **dadurch gekennzeichnet, dass** die Vorlaufleitung (4) und/oder die Rücklaufleitung (5) zumindest abschnittsweise koaxial zu der Schwenkachse (x) geführt sind.

2. Schaltschrank (1) nach Anspruch 1, bei dem die Vorlaufleitung (4) und/oder die Rücklaufleitung (5) in einem koaxial zu der Schwenkachse (x) geführten Abschnitt eine um die Schwenkachse (x) verdrehbare Drehdurchführung (6) aufweist.

3. Schaltschrank nach Anspruch 1 oder 2, bei dem das ein Fluid führende Bauteil (3) über mindestens ein Scharnier (7) an dem Gehäuse (2) anscharniert ist, und bei dem die Vorlaufleitung (4) und/oder die Rücklaufleitung (5) durch eine sich entlang der Schwenkachse (x) erstreckende Durchführung (8) in dem Scharnier (7), oder an einem Scharnier vorbei, geführt ist.

4. Schaltschrank (1) nach Anspruch 3, bei dem das Scharnier (7) eine gehäuseseitige Scharnierhälfte (7.1) und eine bauteilseitige Scharnierhälfte (7.2) aufweist, wobei die Scharnierhälften (7.1, 7.2) fluchtende, sich entlang der Schwenkachse (x) erstreckende Teildurchführungen aufweisen, und wobei die Scharnierhälften (7.1, 7.2) um die Schwenkachse (x) zueinander verdrehbar gelagert sind.

5. Schaltschrank (1) nach einem der vorangegangenen Ansprüche, bei dem das ein Fluid führende Bauteil (3) eine Einhausung (9) aufweist, die zwischen einer Schließstellung, in welcher die Einhausung (9) in einer Öffnung (10) des Gehäuses (2) aufgenommen oder dieser vorgelagert ist, und einer Offenstellung, in welcher die Einhausung (9) die Öffnung (10) freigibt, verschwenkbar ist.

6. Schaltschrank (1) nach Anspruch 5, bei dem die Einhausung (9) im Wesentlichen quaderförmig ist und eine vertikale Seiten- oder Rückwand (11, 12) aufweist, über welche die Einhausung (9) an einer die gehäuseseitige Öffnung (10) umrandenden Stirnseite (13) des Gehäuses (2) anscharniert ist.

7. Schaltschrank (1) nach Anspruch 6, bei dem in der Einhausung (9) ein das Fluid führender Wärmeübertrager (14) aufgenommen ist, an den die Vorlaufleitung (4) und die Rücklaufleitung (5) angeschlossen sind, welche sich von dem Wärmeübertrager (14) durch die Seiten- oder Rückwand (11, 12), oder durch eine andere Begrenzungswand des Schaltschranks (1), hindurch der Schwenkachse (x) annähern und über mindestens ein Umlenkstück (15) in den coaxial zu der Schwenkachse (x) geführten Abschnitt übergeleitet sind.

8. Schaltschrank (1) nach einem der Ansprüche 5 bis 7, bei dem die Einhausung (9) an einer in der Schließstellung dem Gehäuse (2) zugewandten Innenseite eines Türelements angeordnet ist, wobei die Einhausung (9) entweder eine sich parallel beabstandet zu der Innenseite vertikal erstreckende Auslassseite (16) für gekühlte Luft, oder eine sich horizontal erstreckende obere, eine untere, eine linke, oder eine rechte Begrenzungswand (17) mit mindestens einer Luftauslassöffnung (18) für gekühlte Luft aufweist, wobei das Türelement einen Einlass für Umgebungsluft in das Innere der Einhausung (9) aufweist, und wobei ein Luft-Kältemittel-Wärmeübertrager (14) in Luftströmungsrichtung zumindest abschnittsweise zwischen dem Einlass für Umgebungsluft und der Auslassseite (16) für gekühlte Luft angeordnet ist.

9. Schaltschrank (1) nach einem der Ansprüche 5 bis 7, bei dem die Einhausung (9) an einer in der Schließstellung dem Gehäuse (2) zugewandten Innenseite eines Türelements angeordnet ist, wobei die Einhausung (9) in einer parallel zu der Innenseite beabstandeten Bewandung vertikal voneinander beabstandet sowohl einen Auslass für gekühlte Luft, als auch einen Einlass für Warmluft aufweist, wobei ein Luft-Kältemittel-Wärmeübertrager (14) in Luftströmungsrichtung zumindest abschnittsweise zwischen dem Einlass für Warmluft und dem Auslass für gekühlte Luft angeordnet ist.
